# EUROPÄISCHE PATENTSCHRIFT

(11) **EP 0 457 313 B1**
(45) Veröffentlichungstag und Bekanntmachung des Hinweises auf die Patenterteilung: **04.09.1996**
(21) Anmeldenummer: 91107887.1
(22) Anmeldetag: 15.05.1991
(51) Int. Cl.: H01L 25/065, H01L 23/538

(54) **Baugruppe, insbesondere für die Datentechnik**
Assembly group, in particular for data technology
Groupe d'assemblage, en particulier pour la technologie des données

(30) Priorität: 16.05.1990 DE 4015788
(43) Veröffentlichungstag der Anmeldung: 21.11.1991
(73) Patentinhaber: Siemens Nixdorf Informationssysteme Aktiengesellschaft, D-33102 Paderborn (DE)
(72) Erfinder: Wessely, Hermann, Dipl.-Ing., W-8000 München 60 (DE); Fritz, Otmar, Dipl.-Ing., W-8011 Nekeferloh (DE)
(74) Vertreter: Fuchs, Franz-Josef, Dr.-Ing.

(56) Entgegenhaltungen:
- EP-A- 0 332 747
- US-A- 4 283 754
- US-A- 4 771 366
- US-A- 4 868 712
- IBM TECHNICAL DISCLOSURE BULLETIN, Band 19, Nr. 4, September 1976, Seiten 1270- 1271, New York, US; Z. MARKEWYCZ: "Distribution system for multilayer ceramic modules"

## Beschreibung

Die Erfindung betrifft eine Baugruppe, insbesondere für Einrichtungen der Datentechnik.

Für Rechnereinheiten, die auf kleinem Raum immer mehr Schaltfunktionen bewerkstelligen sollen, wird insbesondere bei Baugruppen für Zentralprozessoreinheiten die Herstellung wegen ihrer hohen Lagezahl schwierig. Ebenso kann die Potentialeinspeisung, da pro zur Verfügung stehender Fläche sich die benötigte elektrische Leistung immer stärker erhöht, die dadurch entstehende hohe Verlustleistung nicht auf herkömmlichem Wege über Steckerstifte realisiert werden. Dokument US-A-4 283 754 offenbart eine Baugruppe gemäß dem Oberbegriff des Anspruchs 1.

Aufgabe der vorliegenden Erfindung ist es daher, eine elektrische Baugruppe mit optimalem Platz-Verlustleistungsverhältnis zu schaffen.

Zur Lösung dieser Aufgabe wird gemäß der Erfindung die Baugruppe derart ausegbildet, daß eine mehrlagige, in der üblichen Laminiertechnik erstellte, mit mehreren Potential- und Signallagen versehene Leiterplatte beidseits über Andruckkontakte mit weiteren in Mikroverdrahtungstechnik aufgebauten Leiterplatten verbunden ist, auf deren Rückseiten die für eine vorgegebene elektrische Schaltung benötigten, gehäuselosen integrierten Bausteine (Chips) angeordnet sind, die an ihrer Oberfläche unmittelbar an Kühlplatten anliegen.

Durch diese Maßnahmen erhält man eine Baugruppe, die bei geringem Platzbedarf ein Optimum an Schaltfunktionen zuläßt. Diese Baugruppe ist deshalb besonders für den Einsatz von Universalcomputern mit sehr hohen Rechnerleistungen geeignet.

Die Kühlplatten können dabei vorteilhafterweise flüssigkeitsgekühlt sein. Die Potentiale lassen sich an drei Seiten und die Signale an der verbleibenden vierten Seite über Stecker an die Leiterplatte heranführen.

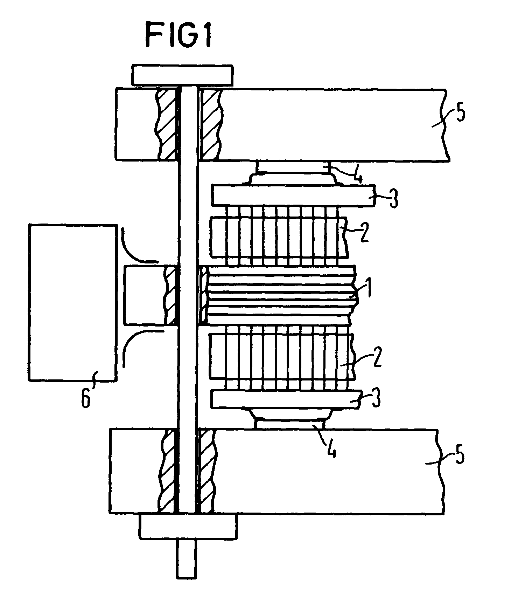

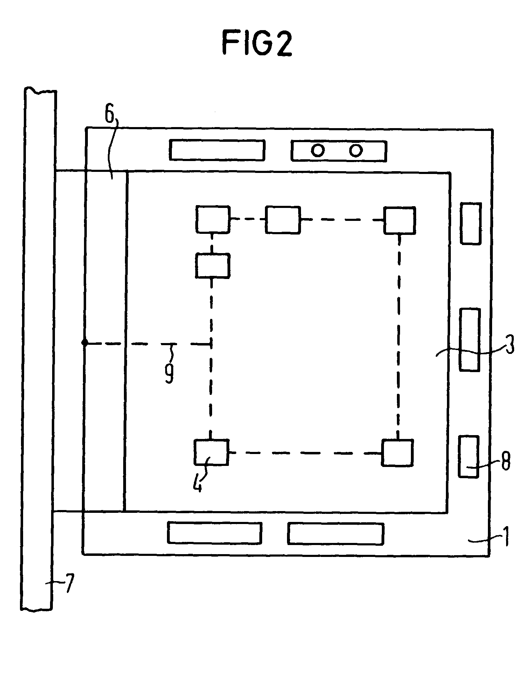

Anhand der Ausführungsbeispiele nach den FIG 1 und 2 wird die Erfindung näher erläutert.

Es zeigen
FIG 1eine Seitenansicht der Baugruppe und
FIG 2eine Detailansicht.

Wie in FIG 1 dargestellt, ist im Zentrum der Baugruppe eine in der üblichen Laminiertechnik aufgebaute Mehrlagenleiterplatte 1 angeordnet, die im vorliegenden Beispiel zwei Signallagen im Inneren und vier Potentiallagen nach außen hin enthält. Diese Leiterplatte 1 ist über Andruckkontakte 2 mit zwei weiteren Leiterplatten verbunden, die in Mikroverdrahtungstechnik aufgebaut sind, und die auf ihrer Rückseite gehäuselose Bausteine 4 (Chips) tragen, wobei die Chips an ihrer Jeweiligen Oberseite unmittelbar mit Kühlplatten 5, die als flüssigkeitsdurchflossene Kühlplatten ausgebildet sein können, kontaktiert sind.

Die Zuführung der Signale und der Potentiale kann über Stecker 6 auf allen vier Seiten einer so entstehenden Baugruppe erfolgen. In FIG 2 ist eine Detailansicht einer Baugruppe gezeigt. Die Leiterplatte 1 ragt auf vier Seiten über die in Mikroverdrahtung aufgebaute, die Bausteine 4 tragende Leiterplatte hinaus. An diesen überstehenden Randbereichen sind an drei Seiten Potentialeinspeisungen 8, die als Kontaktflecken ausgebildet sein können, vorgesehen. Diese Kontaktflecken sind mit den jeweiligen Potentialflächen im Inneren der Leiterplatte 1 über Durchkontaktierungen verbunden. Auf der vierten Seite werden an die Leiterplatte 1 über den Stecker 6 die Signale vom Platter 7 an die Signallagen der Leiterplatte 1 und von da ebenfalls über Durchkontaktierungen (schematisch durch gestrichelte Linien 9 dargestellt) an die Bausteinen 4 herangeführt.

## Patentansprüche

1. Baugruppe, insbesondere für Einrichtungen der Datentechnik, bei der mehrere Leiterplatten übereinander gestapelt angeordnet und mittels Andruckkontakten miteinander verbunden sind,
**dadurch gekennzeichnet**,
daß eine mehrlagige, in der üblichen Laminiertechnik erstellte, mit mehreren Potential- und Signallagen versehene Leiterplatte (1) beidseits über Andruckkontakte (2) mit weiteren in Mikroverdrahtungstechnik aufgebauten Leiterplatten (3) verbunden ist, auf deren Rückseiten die für eine vorgegebene elektrische Schaltung benötigten, gehäuselosen, integrierten Bausteine (4) angeordnet sind, die an ihrer Oberfläche unmittelbar an Kühlplatten (5) anliegen.

2. Baugruppe, insbesondere für Einrichtungen der Datentechnik nach Anspruch 1, **dadurch gekennzeichnet**, daß die Kühlplatten flüssigkeitsgekühlt sind.

3. Baugruppe, insbesondere für Einrichtungen der Datentechnik nach einem der vorhergehenden Ansprüche, **dadurch gekennzeichnet**, daß die Potentiale von drei Seiten und die Signale von der vierten Seite an die in Laminiertechnik aufgebaute Leiterplatte über Stecker (6) herangeführt werden.

## Claims

1. Assembly, in particular for equipment for data technology, in which a plurality of printed circuit boards are arranged in a manner stacked one above the other and are connected to one another by means of pressure contacts, characterized in that a multilayer printed circuit board (1), which is produced using conventional laminating technology and is provided with a plurality of potential layers and signal layers, is connected on both sides, via pressure contacts (2), to further printed circuit boards (3), which are constructed using micro-wiring technology and on the rear sides of which are arranged the integrated modules (4) which are required for a prescribed electrical circuit, have no housings and, at their surface, bear directly against cold plates (5).

2. Assembly, in particular for equipment for data technology, according to Claim 1, characterized in that the cold plates are liquid cooled.

3. Assembly, in particular for equipment for data technology, according to one of the preceding claims, characterized in that the potentials are routed from three sides and the signals from the fourth side, via plugs (6), to the printed circuit board which is constructed using laminating technology.

## Revendications

1. Module, notamment pour des dispositifs de la technique de transmission de données, dans lequel plusieurs plaquettes à circuits imprimés sont empilées l'une au-dessus de l'autre et sont reliées l'une à l'autre au moyen de contacts de pression,
caractérisé en ce que
une plaquette (1) à circuit imprimé, qui a plusieurs couches, qui est fabriquée en technique usuelle de stratification et qui est munie de plusieurs couches de liaison à un potentiel et à un signal, est reliée des deux côtés par l'intermédiaire de contacts (2) de pression à d'autres plaquettes (3) à circuits imprimés, qui sont fabriquées en technique de microcâblage et sur les faces arrières desquelles sont montés les composants (4) intégrés, qui sont sans boîtier, qui sont nécessaires à un circuit électrique prescrit et qui s'appliquent par leur surface directement à des plaquettes (5) de refroidissement.

2. Module, notamment pour des dispositifs de la technique de transmission de données suivant la revendication 1, caractérisé en ce que les plaquettes de refroidissement sont refroidies par du liquide.

3. Module, notamment pour des dispositifs de la technique de transmission de données suivant l'une des revendications précédentes, caractérisé en ce que les potentiels de trois côtés et les signaux du quatrième côté sont amenés à la plaquette à circuits imprimés fabriquée en technique de stratification par l'intermédiaire de fiches (6).
